# EUROPEAN PATENT SPECIFICATION

(11) **EP 2 846 361 B1**
(45) Date of publication and mention of the grant of the patent: **13.05.2020**
(21) Application number: 13182960.8
(22) Date of filing: 04.09.2013
(51) Int. Cl.: H01L 31/0352, H01L 31/05

(54) **Solar cell using printed circuit board**
Solarzelle mit einer Leiterplatte
Cellule solaire utilisant une carte à circuit imprimé

(43) Date of publication of application: 11.03.2015
(73) Proprietor: SOFTPV Inc., Seongnam-si, Gyeonggi-do (KR)
(72) Inventor: Ahn, Hyeon Woo, Daejeon 305-370 (KR); Lee, Sung Gue, Seongnam-si Gyeonggi-do 463-872 (KR)
(74) Representative: Keilitz, Wolfgang

(56) References cited:
- EP-A1- 1 445 804
- EP-A1- 2 551 929
- EP-A1- 2 610 919
- EP-A2- 1 102 332
- WO-A1-2011/105283
- US-A1- 2010 065 863

## Description

The present invention relates to a solar cell having a structure using a printed circuit board (PCB) and a silicon ball.

A solar cell which is a device for converting energy of light into electricity generates electricity using two types of semiconductors, that is, a P-type semiconductor and an N-type semiconductor. When light is applied to a solar cell, electrons and holes are generated in the solar cell. Charge carriers such as the electrons and the holes move to P and N poles, and a potential difference (photovoltaic power) is generated between the P pole and the N pole. In this case, when a load is connected to the solar cell, current starts flowing, which is called a photoelectric effect.

A silicon solar cell that is generally used in a current solar photovoltaic power generation system has a structure including a silicon wafer substrate, an upper electrode, and a lower electrode. The silicon wafer substrate has a P-N junction between a P-layer and an N-layer. In general, an upper layer of the silicon wafer substrate is formed as the N-layer and a lower layer of the silicon wafer substrate is formed as the P-layer. An upper electrode and an anti-reflection film are formed on a top surface of the N-layer, and a lower electrode is formed on a bottom surface of the P-layer. When light is applied to the solar cell having the structure, charge carriers such as electrons and holes are generated in the solar cell, and among the charge carriers, the electrons move toward an N-type semiconductor and the holes move toward a P-type semiconductor. The charge carriers moving to the N- and P-type semiconductors move to electrodes, and thus current starts flowing.
US 2010/0065863 A1 discloses an electronic apparatus, such as a lighting device comprised of light emitting diodes (LEDs) or a power generating apparatus comprising photovoltaic diodes, which may be created through a printing process, using a semiconductor or other substrate particle ink or suspension and using a lens particle ink or suspension. An exemplary apparatus according to US 2010/0065863 A1 comprises a base; at least one first conductor; a plurality of diodes coupled to the at least one first conductor; at least one second conductor coupled to the plurality of diodes; and a plurality of lenses suspended in a polymer deposited or attached over the diodes.

The solar cell constructed as described above has problems in that a light-receiving area is reduced since light is covered by the upper electrode, and in a solar cell module, efficiency is reduced due to conductive resistance of a ribbon that connects cells. In order to improve photoelectric conversion efficiency, there have been attempts to increase a light-receiving area by reducing a line width of an upper electrode and to reduce reflection loss by reducing a reflectance of a solar cell. In addition to such attempts, various studies have been made to reduce solar cell manufacturing costs.

The present invention is directed to a solar cell having a new structure that may increase a light-receiving area using a photoelectric effect generator having a ball shape and may reduce manufacturing costs using a printed circuit board (PCB) structure.

According to the present invention, there is provided a solar cell according to claim 1.

Each of the plurality of photoelectric effect generators may include P-type silicon or N-type silicon, and a diffusion layer having a P-N junction is formed on a surface of the light-receiving portion of the photoelectric effect generator.

A surface of each of the plurality of photoelectric effect generators may have a textured shape. A coating layer coated with an anti-reflection material may be formed on a surface of each of the plurality of photoelectric effect generators.

Each of the plurality of upper electrodes includes a connection portion that is formed to define each of the plurality of fixing holes and is connected to each of the light-receiving portions of the photoelectric effect generators; a first extension portion that extends in a first direction from the connection portion; and an upper communication portion that is formed on an end portion of the first extension portion to define each of the plurality of communication holes.

Each of the plurality of lower electrodes includes a filled portion that is filled in the fixing hole and is connected to the non-light-receiving portion of the photoelectric effect generator; a second extension portion that extends in a second direction, which is opposite to the first direction, from the filled portion; and a lower communication portion that is formed on an end portion of the second extension portion to define the communication hole.

An insulating member for insulating the connection portion and the filled portion may be formed in the fixing hole.

The solar cell may further include an anti-reflection film that is formed by coating an anti-reflection material on the top surface of the substrate. The solar cell may further include: a glass plate that is disposed on a top surface of the anti-reflection film; and a carbon nanotube (CNT)-coating layer that is formed on a top surface of the glass plate, and includes a CNT material.

The solar cell may further include a thermal diffusion film that is stacked on the bottom surface of the substrate, and diffuses heat of the substrate.

The solar cell may further include at least one circuit board that is disposed on the bottom surface of the substrate, and includes a circuit pattern that is electrically connected to each of the plurality of lower electrodes.

Air holes through which air passes to reduce wind resistance may be formed in and through the substrate.

The objects and configurations of the solar cell using the PCB according to the present invention will become more apparent from the detailed description of the exemplary embodiments of the present invention based on the attached drawings.

The above and other objects, features and advantages of the present invention will become more apparent to those of ordinary skill in the art by describing in detail exemplary embodiments thereof with reference to the accompanying drawings, in which:
FIG. 1 is a cross-sectional view illustrating a solar cell using a printed circuit board (PCB) according to an embodiment of the present invention;
FIG. 2 is a plan view illustrating a substrate of FIG. 1 ;
FIG. 3 is a rear view illustrating the substrate of FIG. 1 ;
FIG. 4 is an enlarged cross-sectional view illustrating a silicon ball of FIG. 1 ;
FIG. 5 is a plan view illustrating the substrate on which upper electrodes are arranged;
FIG. 6 is a rear view illustrating the substrate on which lower electrodes are arranged; and
FIG. 7 is a cross-sectional view illustrating a solar cell using a PCB according to another embodiment of the present invention.

Exemplary embodiments of the present invention will be described in detail below with reference to the accompanying drawings.

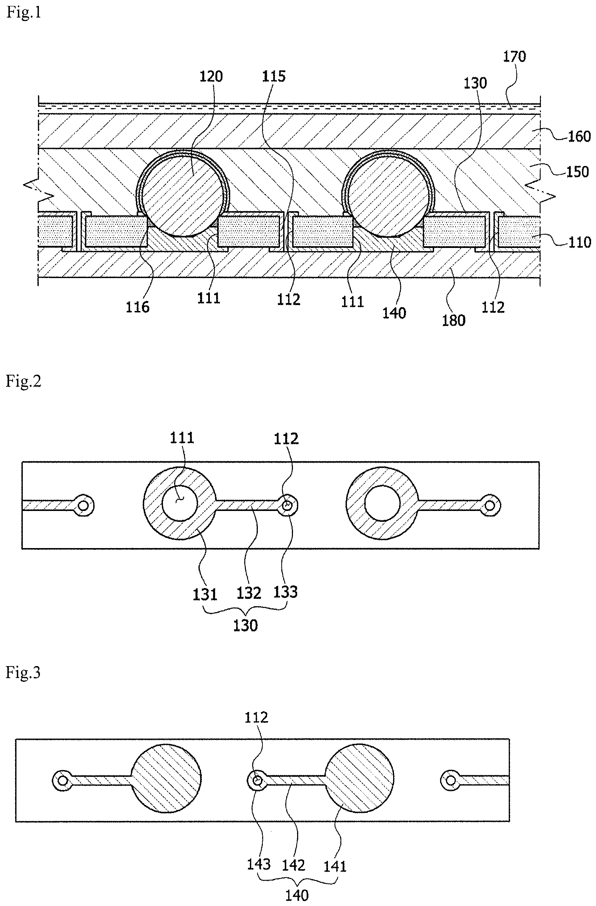

FIG. 1 is a cross-sectional view illustrating a solar cell using a printed circuit board (PCB) according to an embodiment of the present invention. FIG. 2 is a plan view illustrating a substrate 110 of FIG. 1. FIG. 3 is a rear view illustrating the substrate 110 of FIG. 1 .

Referring to FIGS. 1 through 3 , the solar cell includes the substrate 110 formed of an insulating material, a plurality of photoelectric effect generators that are provided on the substrate 110, a plurality of upper electrodes 130 that are formed on a top surface of the substrate 110, and a plurality of lower electrodes 140 that are formed on a bottom surface of the substrate 110.

A substrate used for a general PCB is used as the substrate 110 formed of an insulating material. The substrate 110 may be formed of a material such as an epoxy resin, a phenolic resin, or a polyimide.

A plurality of fixing holes 111 and communication holes 112 are alternately formed in and through the substrate 110. The fixing holes 111 and the communication holes 112 are alternately formed in a specific direction. The fixing holes 111 provide spaces for communicating silicon balls 120 and the lower electrodes 140, and the communication holes 112 provide spaces for communicating the upper electrodes 130 and the lower electrodes 140.

The photoelectric effect generators are fixed to the substrate 110 and function to generate photoelectric effects when receiving light. Each of the photoelectric effect generators may be formed of a semiconductor material capable of generating a photoelectric effect, for example, silicon or gallium arsenide (GaAs).

In FIGS. 1 through 3 , the photoelectric effect generator has a ball shape in order to increase a light-receiving portion. The term "ball shape" used herein encompasses a shape having a curved outer surface such as a spherical shape and an oval shape.

The photoelectric effect generator may have a structure formed of a semiconductor material capable of generating a photoelectric effect, or may have a structure formed by coating a semiconductor material capable of generating a photoelectric effect on a ball outer surface of an insulating material (for example, plastic or glass). In the latter structure, examples of the semiconductor material coated on the ball or polyhedral outer surface may include silicon, CdTe, and CIGS.

The following explanation will be made on the assumption that the photoelectric effect generator is formed of silicon and has a ball shape, and the 'photoelectric effect generator' will be referred to as the 'silicon ball' 120 for convenience of explanation. Accordingly, descriptions of the silicon ball 120 may apply to another type of photoelectric effect generator.

The plurality of silicon balls 120 are fixed to the substrate 110 to be disposed over the fixing holes 111. The silicon balls 120 may be fixed to the substrate 110 by being partially inserted into the respective fixing holes 111, and have diameters greater than diameters of the fixing holes 111. The silicon balls 120 generate photoelectric effects by receiving light through portions (hereinafter referred to as 'exposed portions') that are exposed to an upper portion of the substrate 110.

Configurations of the silicon balls 120 will be explained below in detail.

Although the silicon balls 120 are inserted into the fixing holes 111 in FIGS. 1 through 3 , the present embodiment is not limited thereto and the silicon balls 120 may not be inserted into the fixing holes 111 according to shapes and sizes of the photoelectric effect generators.

The plurality of upper electrodes 130 are formed on the top surface of the substrate 110, and are connected to respective light-receiving portions (that is, the exposed portions) of the silicon balls 120. Referring to FIG. 2 , each of the upper electrodes 130 include a connection portion 131, a first extension portion 132, and an upper communication portion 133.

The connection portion 131 is formed to define each of the fixing holes 111 and is connected to the light-receiving portion of each of the silicon balls 120. The connection portion 131 may be formed to have a ring shape, and is electrically connected to the silicon ball 120 by contacting the light-receiving portion of the silicon ball 120.

The first extension portion 132 extends in a first direction (rightward in FIG. 2) from the connection portion 131. The first extension portion 132 extends in the first direction from the connection portion 131 to reach each of the communication holes 112 that is far away from the connection portion 131 in the first direction.

The upper communication portion 133 is formed on an end portion of the first extension portion 132 to define the communication hole 112. The upper communication portion 133 may be formed to have a ring shape, like the connection portion 131.

The plurality of lower electrodes 140 are formed on the bottom surface of the substrate 110, and are connected to respective non-light-receiving portions that are inserted into the fixing holes 111 of the silicon balls 120. The lower electrodes 140 communicate with the upper electrodes 130 through the communication holes 112 and are electrically connected in series to the respective silicon balls 120.

Referring to FIG. 3 , each of the lower electrodes 140 includes a filled portion 141, a second extension portion 142, and a lower communication portion 143.

The filled portion 141 is filled in each of the fixing holes 111 and is connected to the non-light-receiving portion of each of the silicon balls 120. The filled portion 141 is formed by filling a conductive material in the fixing hole 111. An insulating member 116 for insulating the connection portion 131 and the filled portion 141 may be formed in the fixing hole 111.

The second extension portion 142 extends in a second direction (that is opposite to the first direction, leftward in FIG. 3) from the filled portion 141, to reach the communication hole 112 that is far away from the filled portion 141 in the second direction.

The lower communication portion 143 is formed on an end portion of the second extension portion 142 to define the communication hole 112. The lower communication portion 143 may be formed to have a ring shape like the upper communication portion 133, and is connected to the upper communication portion 133 of the upper electrode 130 through a plating layer 115 that is formed on an inner wall of the communication hole 112.

Each of the upper electrode 130 and the lower electrode 140 may be formed of a conductive material such as copper or silver, and may be formed using the same method as that used to form a general circuit pattern of the PCB. In the above configuration, the light-receiving portion of the silicon ball 120 is electrically connected to the lower electrode 140 that is far away in the first direction through the upper electrode 130, and the non-light-receiving portion of the silicon ball 120 is electrically connected to the upper electrode 130 that is far away in the second direction through the lower electrode 140.

An anti-reflection film 150 is formed by coating an anti-reflection material (for example, a fluorine-based resin, nanoparticles, SiO2 or TiO2) on the top surface of the substrate 110, and an over-coating layer 180 formed of an insulating material is formed on the bottom surface of the substrate 110 to protect the lower electrode 140.

A light-transmitting plate 160 formed of a light-transmitting material through which light is transmitted (for example, glass) is disposed on a top surface of the anti-reflection film 150 to protect the upper electrode 130. A carbon nanotube (CNT)-coating layer 170 including a CNT material may be formed on a top surface of the light-transmitting plate 160. The CNT-coating layer 170 reduces a reflectance so that a maximum amount of light is transmitted to the silicon ball 120.

A thermal diffusion film for diffusing heat of the substrate 110 may be additionally stacked on the bottom surface of the substrate 110. The thermal diffusion film functions to emit heat of the substrate 110 to the outside, and may be attached to a bottom surface of the over-coating layer 180 when the over-coating layer 180 is included.

In the solar cell constructed as described above, since light is absorbed using the silicon ball 120, a light-receiving area may be greater than that of a conventional flat panel solar cell. Since the upper electrode 130 is disposed under the silicon ball 120, the problem that light is covered by the upper electrode 130 may be solved. In addition, since the solar cell may be manufactured using a method of manufacturing a circuit pattern of a PCB, a manufacturing process may be simplified and manufacturing costs may be reduced.

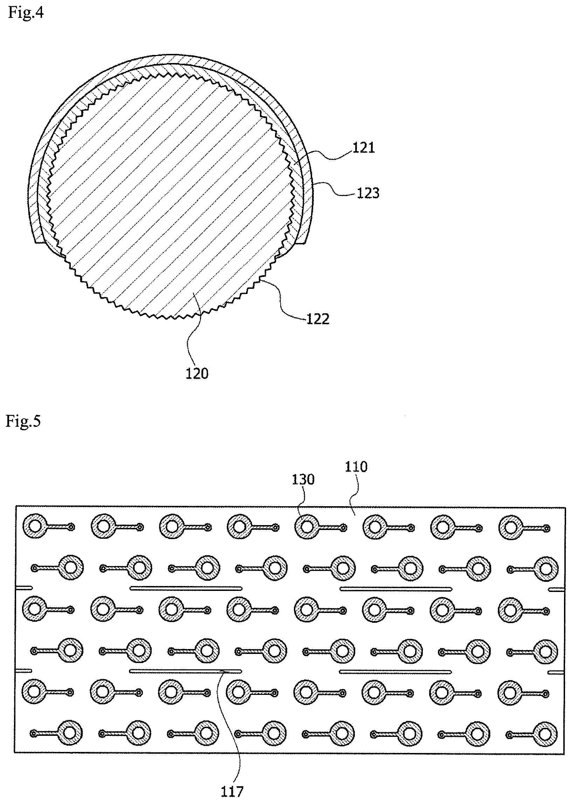

FIG. 4 is an enlarged cross-sectional view illustrating the silicon ball 120 of FIG. 1 .

The silicon ball 120 includes P-type silicon or N-type silicon, and a diffusion layer 121 having a P-N junction is formed on a surface of the light-receiving portion of the silicon ball 120. The silicon ball 120 may additionally include a P-type or N-type dopant.

In FIG. 4 , the silicon ball 120 is formed of P-type silicon, and the diffusion layer 121 that is an N-type layer is formed on a surface of the silicon ball 120. In this case, the diffusion layer 121 may be formed by diffusing POCl3 or H3PO4 including group V elements in the silicon ball 120 formed of P-type silicon at a high temperature and performing a doping process. The doping process may be performed in a state where the silicon ball 120 is attached to the substrate 110. In this case, a POCl3 layer or a H3PO4 layer is additionally formed on the substrate 110.

Although the silicon ball 120 is formed of silicon in FIG. 4 , the silicon ball 120 may be formed by coating silicon on an insulating ball.

The connection portion 131 of the upper electrode 130 contacts the diffusion layer 121 and an N pole, and the filled portion 141 of the lower electrode 140 is connected to a P pole of the silicon ball 120. When light is applied to the silicon ball 120, electrons and holes are generated in the silicon ball 120, and the electrons move toward the diffusion layer 121 and the upper electrode 130 and the holes move toward the lower electrode 140, thereby causing current to start flowing.

A surface of the silicon ball 120 may have a textured shape 122 in order to reduce reflectance, and a coating layer 123 coated with an anti-reflection material may be additionally formed on the surface of the silicon ball 120. Since the textured surface is formed on the silicon ball 120, the coating layer 123 for anti-reflection is formed on the surface of the silicon ball 120, and the CNT-coating layer 170 is formed on the light-transmitting plate 160, reflection loss may be greatly reduced.

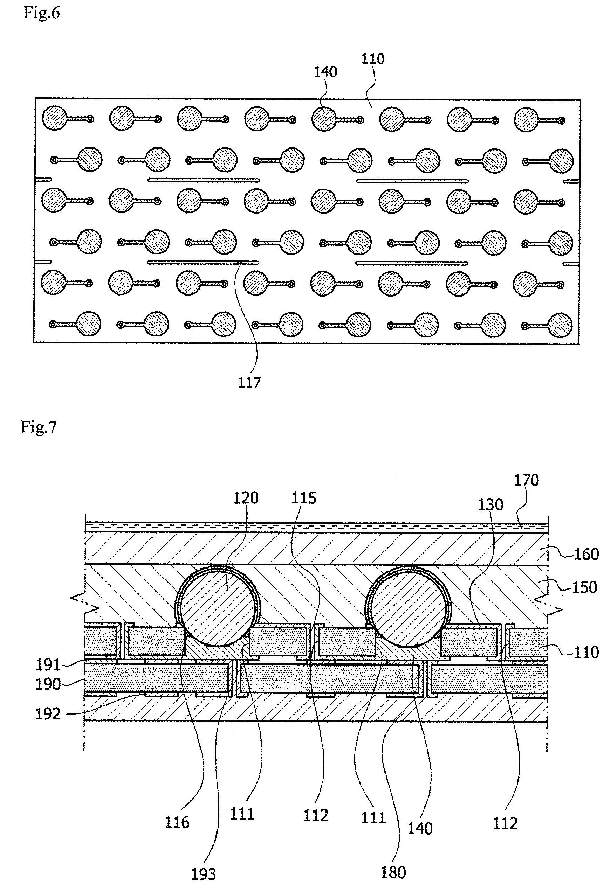

FIG. 5 is a plan view illustrating the substrate 110 on which the upper electrodes 130 are arranged. FIG. 6 is a rear view illustrating the substrate 110 on which the lower electrodes 140 are arranged.

Referring to FIGS. 5 and 6 , the upper electrodes 130 are arranged to form a plurality of columns, and the lower electrodes 140 are arranged to correspond to the upper electrodes 130. The present embodiment is not limited thereto, and the solar cell may be manufactured to have any of various other structures according to pattern shapes and arrangements of the upper electrodes 130.

In particular, unlike a conventional silicon solar cell including a solar cell module that is formed by connecting a plurality of cells, the solar cell according to the present invention may be manufactured to have any of various areas according to an area of the substrate 110 and the number of the silicon balls 120. Also, since a ribbon for connecting cells is not required, power loss that occurs due to conductive resistance of the ribbon may be avoided.

A plurality of air holes 117 through which air passes in order to reduce wind resistance may be formed in and through the substrate 110. The air holes 117 may vertically pass through the top and bottom surfaces of the substrate 110, and thus wind may pass through the top and bottom surfaces of the substrate 110. Although the air holes 117 having slit shapes are formed at predetermined intervals in FIGS. 5 and 6, shapes and the number of the air holes 117 may be variously changed.

FIG. 7 is a cross-sectional view illustrating a solar cell using a PCB according to another embodiment of the present invention.

The solar cell of FIG. 7 additionally includes a circuit board 190 for performing a specific function when compared to the solar cell of the previous embodiment. The circuit board 190 is disposed on the bottom surface of the substrate 110, and includes upper and lower circuit patterns 191 and 192 that are electrically connected to the lower electrode 140.

As such, since the solar cell of FIG. 7 has a PCB structure, the solar cell may have an integrated structure by stacking the circuit board 190 having a specific function. For example, when the solar cell is connected to an energy storage system (ESS), the circuit board 190 may be provided with a function of connecting the solar cell and the ESS and converting a signal.

The upper pattern 191 and the lower pattern 192 are respectively provided on a top surface and a bottom surface of the circuit board 190 in FIG. 7 . Accordingly, the upper pattern 191 and the lower pattern 192 communicate with each other through a plating layer 193 that is formed on an inner wall of a communication hole. The circuit board 190 is not limited thereto, and a shape and the number of the circuit board(s) 190 added to the solar cell may be variously changed. For example, the circuit board 190 may be formed as a single layer, or two or more circuit boards 190 may be stacked as multiple layers.

As described above, according to a solar cell of the present invention constructed as described above, since light is absorbed using a photoelectric effect generator having a ball or polyhedral shape, a light-receiving area may be greater than that of a conventional flat panel solar cell, and since an upper electrode is disposed under the photoelectric effect generator, the problem that light is covered by the upper electrode may be solved.

Also, since the solar cell may be manufactured using a method of manufacturing a circuit pattern of a PCB, a manufacturing process may be simplified and manufacturing costs may be reduced.

Reflection loss may be greatly reduced due to a textured structure formed on a surface of a silicon ball, an anti-reflection coating layer of the silicon ball, and a CNT-coating layer of a glass plate.

Also, the solar cell may be manufactured to have any of various areas according to an area of a substrate and the number of silicon balls. Since a ribbon for connecting cells in not required, power loss that occurs due to conductive resistance of the ribbon may be avoided.

## Claims

1. A solar cell using a printed circuit board, PCB, the solar cell comprising:
a substrate (110) that is formed of an insulating material and in and through which a plurality of fixing holes (111) and communication holes (112) are alternately formed;
a plurality of photoelectric effect generators (120) that have a ball shape fixed to the substrate to be disposed over the plurality of fixing holes, and generate photoelectric effects by receiving light through light-receiving portions that are exposed to an upper portion of the substrate;
a plurality of upper electrodes (130) that are formed on a top surface of the substrate, and are connected to the respective light-receiving portions of the photoelectric effect generators; and
a plurality of lower electrodes (140) that are formed on a bottom surface of the substrate to be connected to respective non-light-receiving portions of the photoelectric effect generators, and communicate with the plurality of upper electrodes through the plurality of communication holes,
wherein each of the plurality of upper electrodes comprises:
a connection portion (131) that is formed to define each of the plurality of fixing holes and is connected to each of the light-receiving portions of the photoelectric effect generators by contacting with each of the light-receiving portions;
a first extension portion (132) that extends in a first direction from the connection portion; and
an upper communication portion (133) that is formed on an end portion of the first extension portion to define each of the plurality of communication holes,
wherein each of the plurality of lower electrodes comprises:
a filled portion (141) that is filled in the fixing hole and is connected to the non-light-receiving portion of the photoelectric effect generator;
a second extension portion (142) that extends in a second direction, which is opposite to the first direction, from the filled portion; and
a lower communication portion (143) that is formed on an end portion of the second extension portion to define the communication hole,
wherein each of the plurality of photoelectric effect generators have diameters greater than diameters of the fixing holes so as to be partially inserted into the fixing holes, and
wherein the lower communication portion of the lower electrode is connected to the upper communication portion of the upper electrode through a plating layer on the inner wall of the communication hole.

2. The solar cell of claim 1, wherein each of the plurality of photoelectric effect generators comprises P-type silicon or N-type silicon, and a diffusion layer (121) having a P-N junction is formed on a surface of the light-receiving portion of the photoelectric effect generator.

3. The solar cell of claim 1 or 2, wherein a surface of each of the plurality of photoelectric effect generators has a textured shape (122).

4. The solar cell of claim 1, 2, or 3, wherein a coating layer (123) coated with an anti-reflection material is formed on a surface of each of the plurality of photoelectric effect generators.

5. The solar cell of claim 1, wherein an insulating member (116) for insulating the connection portion and the filled portion is formed in the fixing hole.

6. The solar cell of any one of claims 1 to 5, further comprising an anti-reflection film (150) that is formed by coating an anti-reflection material on the top surface of the substrate.

7. The solar cell of claim 6, further comprising:
a glass plate (160) that is disposed on a top surface of the anti-reflection film; and
a carbon nanotube, CNT, -coating layer (170) that is formed on a top surface of the glass plate, and comprises a CNT material.

8. The solar cell of any one of claims 1 to 7, further comprising a thermal diffusion film that is stacked on the bottom surface of the substrate, and diffuses heat of the substrate.

9. The solar cell of any one of claims 1 to 8, further comprising at least one circuit board (190) that is disposed on the bottom surface of the substrate, and comprises a circuit pattern that is electrically connected to each of the plurality of lower electrodes.

10. The solar cell of any one of claims 1 to 9, wherein air holes (117) through which air passes to reduce wind resistance are formed in and through the substrate.

## Patentansprüche

1. Solarzelle unter Verwendung einer Leiterplatte, PCB, wobei die Solarzelle umfasst:
ein Substrat (110), das aus einem Isoliermaterial gebildet ist und in dem abwechselnd mehrere Befestigungslöcher (111) und Kommunikationslöcher (112) ausgebildet sind;
mehrere photoelektrische Effektgeneratoren (120), die Kugel- oder Polyederformen aufweisen und die an dem Substrat befestigt sind, um über den mehreren Befestigungslöchern angeordnet zu werden, und photoelektrische Effekte durch Empfangen von Licht durch lichtempfangende Abschnitte erzeugen, die einem oberen Abschnitt des Substrats ausgesetzt sind;
eine Vielzahl von oberen Elektroden (130), die auf einer oberen Oberfläche des Substrats ausgebildet sind und mit den jeweiligen lichtempfangenden Abschnitten der fotoelektrischen Effektgeneratoren verbunden sind;
und eine Vielzahl von unteren Elektroden (140), die auf einer Bodenfläche des Substrats ausgebildet sind, um mit jeweiligen nicht-lichtempfangenden Abschnitten der photoelektrischen Effektgeneratoren verbunden zu werden, und mit der Vielzahl von oberen Elektroden über die Vielzahl von Kommunikationslöchern in Verbindung stehen,
wobei jede der Vielzahl der von oberen Elektroden Folgendes umfasst:
einen Verbindungsabschnitt (131), der dazu ausgebildet ist, jedes der Mehrzahl von Befestigungslöchern zu definieren und der mit jedem der lichtempfangenden Abschnitte der photoelektrischen Effektgeneratoren verbunden ist;
einen ersten Verlängerungsabschnitt (132), der sich von dem Verbindungsabschnitt in einer ersten Richtung erstreckt; und
einen oberen Verbindungsabschnitt (133), der an einem Endabschnitt des ersten Verlängerungsabschnitts ausgebildet ist, um jedes der mehreren Verbindungslöcher zu definieren,
wobei jede der Vielzahl von unteren Elektroden umfasst:
einen gefüllten Abschnitt (141), der in das Befestigungsloch gefüllt ist und mit dem nicht-lichtempfangenden Abschnitt des fotoelektrischen Effektgenerators verbunden ist;
einen zweiten Verlängerungsabschnitt (142), der sich von dem gefüllten Abschnitt in einer zweiten Richtung erstreckt, die der ersten Richtung entgegengesetzt ist;
und einen unteren Verbindungsabschnitt (143), der an einem Endabschnitt des zweiten Verlängerungsabschnitts ausgebildet ist, um das Verbindungsloch zu definieren,
wobei jeder der photoelektrischen Effektgeneratoren einen Durchmesser aufweist, der größer ist als der Durchmesser eines Befestigungslochs, um teilweise in die Befestigungslöcher eingesetzt zu werden, und
wobei der untere Verbindungsabschnitt der unteren Elektrode mit dem oberen Verbindungsabschnitt der oberen Elektrode über eine Metallschicht an der Innenwand des Verbindungslochs verbunden ist.

2. Solarzelle nach Anspruch 1, wobei jeder der Vielzahl von fotoelektrischen Effektgeneratoren Silizium vom P-Typ oder vom N-Typ umfasst und eine Diffusionsschicht (121) mit einem PN-Übergang auf einer Oberfläche des lichtempfangenden Abschnitts des fotoelektrischen Effektgenerators ausgebildet ist.

3. Solarzelle nach Anspruch 1 oder 2, wobei eine Oberfläche von jedem der Vielzahl von fotoelektrischen Effektgeneratoren eine strukturierte Form (122) aufweist.

4. Solarzelle nach Anspruch 1, 2 oder 3, wobei eine Überzugsschicht (123), die mit einem Antireflexionsmaterial beschichtet ist, auf einer Oberfläche jedes der Vielzahl von fotoelektrischen Effektgeneratoren ausgebildet ist.

5. Solarzelle nach Anspruch 1, wobei ein Isolierelement (116) zum Isolieren des Verbindungsabschnitts und des gefüllten Abschnitts in dem Befestigungsloch ausgebildet ist.

6. Solarzelle nach einem der Ansprüche 1 bis 5, ferner umfassend einen Antireflexionsfilm (150), der durch Beschichten eines Antireflexionsmaterials auf die obere Oberfläche des Substrats gebildet wird.

7. Solarzelle nach Anspruch 6, ferner umfassend:
eine Glasplatte (160), die auf einer oberen Oberfläche des Antireflexionsfilms angeordnet ist; und
eine Kohlenstoffnanoröhren-CNT-Überzugsschicht (170), die auf einer oberen Oberfläche der Glasplatte ausgebildet ist und ein CNT-Material umfasst.

8. Solarzelle nach einem der Ansprüche 1 bis 7, ferner umfassend einen Wärmediffusionsfilm, der auf der Unterseite des Substrats gestapelt ist und Wärme des Substrats abgibt.

9. Solarzelle nach einem der Ansprüche 1 bis 8, ferner umfassend mindestens eine Leiterplatte (190), die auf der Unterseite des Substrats angeordnet ist und ein Schaltungsmuster aufweist, das mit jeder der mehreren unteren Elektroden elektrisch verbunden ist.

10. Solarzelle nach einem der Ansprüche 1 bis 9, wobei Luftlöcher, durch die Luft strömt, um den Windwiderstand zu verringern, in und durch das Substrat ausgebildet sind.

## Revendications

1. Cellule solaire utilisant une carte de circuit imprimé, PCB, la cellule solaire comprenant :
un substrat (110) qui est formé d'un matériau isolant et dans et à travers lequel une pluralité de trous de fixation (111) et de trous de communication (112) sont formés de façon alternée ;
une pluralité de générateurs d'effets photo-électriques (120), qui ont une forme sphérique, fixés au substrat pour être disposés par-dessus la pluralité de trous de fixation, et génèrent des effets photo-électriques en recevant de la lumière par l'intermédiaire de des parties de réception de lumière qui sont exposées à une partie supérieure du substrat ;
une pluralité d'électrodes supérieures (130) qui sont formées sur une surface supérieure du substrat, et sont connectées aux parties de réception de lumière respectives des générateurs d'effets photo-électriques ; et
une pluralité d'électrode inférieures (140) qui sont formées sur une surface inférieure du substrat pour être connectées à des parties de non-réception de lumière respectives des générateurs d'effets photo-électriques, et communiquent avec la pluralité d'électrodes supérieures par l'intermédiaire de la pluralité de trous de communication,
dans laquelle chacune de la pluralité d'électrodes supérieures comprend :
une partie de connexion (131) qui est formée pour définir chacun de la pluralité de trous de fixation et est connectée à chacune des parties de réception de lumière des générateurs d'effets photo-électriques en entrant en contact avec chacune des parties de réception de lumière ;
une première partie d'extension (132) qui s'étend dans une première direction à partir de la partie de connexion ; et
une partie de communication supérieure (133) qui est formée sur une partie d'extrémité de la première partie d'extension pour définir chacun de la pluralité de trous de communication,
dans laquelle chacune de la pluralité d'électrode inférieures comprend :
une partie de remplissage (141) qui remplit le trou de fixation et est connectée à la partie de non-réception de lumière du générateur d'effets photo-électriques ;
une seconde partie d'extension (142) qui s'étend dans une seconde direction, qui est opposée à la première direction, à partir de la partie de remplissage ; et
une partie de communication inférieure (143) qui est formée sur une partie d'extrémité de la seconde partie d'extension pour définir le trou de communication,
dans laquelle chacun de la pluralité de générateurs d'effets photo-électriques a un diamètre supérieur aux diamètres des trous de fixation afin d'être partiellement inséré dans les trous de fixation, et
dans laquelle la partie de communication inférieure de l'électrode inférieure est connectée à la partie de communication supérieure de l'électrode supérieure par l'intermédiaire d'une couche de placage sur la paroi intérieure du trou de communication.

2. Cellule solaire selon la revendication 1, dans laquelle chacun de la pluralité de générateurs d'effets photo-électriques comprend du silicium de type P ou du silicium de type N, et une couche de diffusion (121) ayant une jonction P-N est formée sur une surface de la partie de réception de lumière du générateur d'effets photo-électriques.

3. Cellule solaire selon la revendication 1 ou 2, dans laquelle une surface de chacun de la pluralité de générateurs d'effets photo-électriques a une forme texturée (122).

4. Cellule solaire selon la revendication 1, 2, ou 3, dans laquelle une couche de revêtement (123) enduite avec un matériau anti-réflexion est formé sur une surface de chacun de la pluralité de générateurs d'effets photo-électriques.

5. Cellule solaire selon la revendication 1, dans laquelle un élément isolant (116) pour isoler la partie de connexion et la partie de remplissage est formée dans le trou de fixation.

6. Cellule solaire selon l'une quelconque des revendications 1 à 5, comprenant en outre un film anti-réflexion (150) qui est formé en appliquant un matériau anti-réflexion sur la surface supérieure du substrat.

7. Cellule solaire selon la revendication 6, comprenant en outre :
une plaque de verre (160) qui est disposée sur une surface supérieure du film anti-réflexion ; et
une couche de revêtement à nanotubes de carbone, CNT, (170) qui est formée sur une surface supérieure de la plaque de verre, et comprend un matériau à CNT.

8. Cellule solaire selon l'une quelconque des revendications 1 à 7, comprenant en outre un film à diffusion thermique qui est empilé sur la surface inférieure du substrat, et diffuse de la chaleur du substrat.

9. Cellule solaire selon l'une quelconque des revendications 1 à 8, comprenant en outre au moins une carte de circuit imprimé (190) qui est disposée sur la surface inférieure du substrat, et comprend un motif de circuit qui est électriquement connecté à chacune de la pluralité d'électrode inférieures.

10. Cellule solaire selon l'une quelconque des revendications 1 à 9, dans laquelle des trous d'air (117) à travers lesquels de l'air passe pour réduire la résistance aérodynamique sont formés dans et à travers le substrat.
